# FASCICULE DE BREVET EUROPEEN

(11) **EP 0 938 095 B1**
(45) Date de publication et mention de la délivrance du brevet: **13.08.2003**
(21) Numéro de dépôt: 99410010.5
(22) Date de dépôt: 19.02.1999
(51) Int. Cl.: G11C 8/00, G11C 16/06

(54) **Mémoire programmable non-volatile et procédé de programmation d'une telle mémoire**
Programmierbarer nichtflüchtiger Speicher und Verfahren zu dessen Programmierung
Programmable non-volatile memory and programming method thereof

(30) Priorité: 19.02.1998 FR 9802221
(43) Date de publication de la demande: 25.08.1999
(73) Titulaire: STMicroelectronics S.A., 92120 Montrouge (FR)
(72) Inventeur: Schoellkopf, Jean-Pierre, 38000 Grenoble (FR)
(74) Mandataire: de Beaumont, Michel

(56) Documents cités:
- EP-A- 0 242 854
- US-A- 5 381 370

## Description

La présente invention concerne une mémoire programmable et non-volatile, comportant des rangées de cellules mémoire supplémentaires par rapport à la capacité d'adressage d'un bus d'adresses. Ces rangées supplémentaires sont destinées à une reprogrammation non-volatile lorsque les données stockées dans une rangée de la mémoire doivent être modifiées.

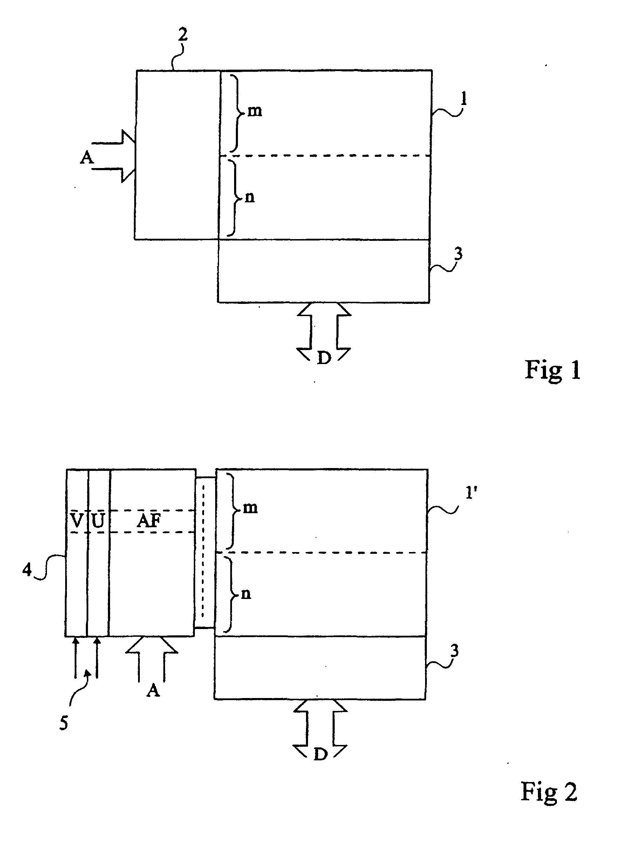

La figure 1 représente, de façon très schématique, un exemple de mémoire programmable non-volatile classique. Cette mémoire comporte un réseau 1 de cellules mémoire non-volatiles (ou points mémoire permanents) organisées en matrice de rangées et de colonnes. Le nombre de colonnes correspond généralement au nombre de bits d'un mot de données devant être stocké dans la mémoire. Le nombre de rangées est ici choisi pour être supérieur au nombre de rangées dans laquelle doivent être stockées des données, c'est-à-dire au nombre d'adresses utilisées sur un bus d'adresses A. Par exemple, la mémoire est prévue pour contenir m mots de données et comprend m+n rangées de cellules mémoire. Les n rangées de cellules mémoire supplémentaires (ou redondantes) sont destinées à permettre une reprogrammation non-volatile de la mémoire.

Le réseau 1 est associé à un circuit 2 de décodage et d'aiguillage d'adresses A de rangées. Le circuit 2 est chargé de sélectionner une rangée de cellules mémoire en fonction de l'adresse A présente en entrée. En colonne, le réseau 1 est associé à un circuit 3 d'amplificateurs de lecture/écriture recevant et restituant les données D sur un nombre de bits généralement identique au nombre de colonnes.

En pratique, le circuit 2 constitue une matrice de commutateurs propre à aiguiller des sorties d'un élément de décodage d'adresses pour les connecter à m lignes de mots sélectionnant une rangée de cellules mémoire du réseau 1. Une rangée donnée du réseau 1 ne peut être programmée qu'une seule fois, et les n rangées supplémentaires servent à permettre une reprogrammation non-volatile de la mémoire globale. Dans l'exemple représenté en figure 1, il y a donc n possibilités de reprogrammation de la mémoire, après quoi la mémoire non-volatile n'est plus reprogrammable.

La structure des points mémoire non-volatiles est, par exemple, constituée d'éléments fusibles qui, une fois programmés dans un état actif, ne peuvent plus revenir dans l'autre état.

La présente invention vise à améliorer les possibilités de reprogrammation d'une mémoire non-volatile.

La présente invention vise, en particulier, à proposer un nouveau système d'adressage d'une mémoire non-volatile qui augmente le nombre de reprogrammations possibles pour un nombre donné de rangées redondantes. Ainsi, l'invention vise à augmenter virtuellement la capacité de reprogrammation d'une mémoire non-volatile sans augmenter d'autant son encombrement physique.

Pour atteindre ces objets, la présente invention prévoit une mémoire non-volatile programmable comprenant une pluralité de rangées mémoire accessibles par un bus d'adresses, le nombre (m+n) de rangées étant supérieur au nombre (m) d'adresses utilisées sur le bus d'adresses ; et des moyens pour associer des rangées choisies de la mémoire à des adresses respectives ; ces moyens comprenant une mémoire associative ayant un emplacement programmable pour chaque rangée mémoire, ledit emplacement ayant un champ d'adresse et deux bits d'états, et étant prévu pour, en lecture, sélectionner sa rangée mémoire respective lorsqu'il contient l'adresse présente sur le bus d'adresses et que les deux bits d'états sont respectivement à un état inactif et actif.

Selon un mode de réalisation de la présente invention, toutes les adresses utilisées sur le bus d'adresses sont contenues à des emplacements respectifs dont les bits d'état sont respectivement à l'état inactif et actif, les bits d'état des emplacements restants étant tous deux à un état actif, ou tous deux à un état inactif.

Selon un mode de réalisation de la présente invention, chaque emplacement comprend une pluralité de cellules mémoire correspondant respectivement aux lignes du bus d'adresses et à des lignes de commande des bits d'état.

La présente invention prévoit aussi un procédé de reprogrammation de la mémoire ci-dessus consistant à exécuter les étapes successives suivantes : comparer, pour chaque couple comprenant une adresse dans la mémoire associative et une donnée dans le réseau mémoire, la donnée présente sur un bus de données avec la donnée stockée de façon non-volatile dans le réseau mémoire ; reprogrammer, si possible, la nouvelle donnée par rapport à l'ancienne donnée ; et dans le cas contraire, mémoriser l'adresse correspondante comme étant réutilisable et mémoriser le couple d'adresse/ donnée comme étant à reloger.

Selon un mode de réalisation de la présente invention, le procédé consiste, dans une deuxième étape à rechercher, pour chaque couple d'adresse/donnée à reloger, l'existence d'une rangée réutilisable dans laquelle la nouvelle donnée pourrait être reprogrammée avec cette donnée à reloger et, dans la négative, à utiliser une rangée supplémentaire libre pour programmer la donnée correspondante.

Selon un mode de réalisation de la présente invention, le procédé consiste, lors de l'utilisation d'une nouvelle rangée, à placer les bits d'état dans des états respectifs inactif et actif.

Selon un mode de réalisation de la présente invention, le procédé consiste, dans une troisième étape, à marquer toutes les adresses réutilisables qui n'ont pas été reprogrammées comme étant invalides en plaçant les deux bits d'états correspondants dans un état inactif.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment est destinée à exposer l'état de la technique et le problème posé ; et
la figure 2 représente un mode de réalisation d'une mémoire non-volatile reprogrammable selon la présente invention.

Pour des raisons de clarté, seuls les éléments de la mémoire non-volatile et de son circuit d'adressage qui sont nécessaires à la compréhension de l'invention ont été représentés à la figure 2 et seront décrits par la suite.

La présente invention a recours à un réseau 1' de cellules ou points mémoire non-volatiles classiques, c'est-à-dire comprenant un nombre m de rangées correspondant au nombre de rangées adressables au moyen d'un bus d'adresses A et n rangées supplémentaires ou redondantes destinées à permettre une reprogrammation. De même, le réseau mémoire 1' est associé à des amplificateurs de lecture/écriture classiques 3 reliés à un bus de données D.

Une caractéristique de la présente invention est que les m+n rangées du réseau 1' de cellules mémoire sont adressées par une mémoire associative 4, c'est-à-dire une mémoire ayant un emplacement programmable pour chaque rangée mémoire (ligne de mot). Dans l'exemple représenté, il y a m lignes de mot adressables et n lignes de mot de reprogrammation. La mémoire associative 4 est prévue pour sélectionner une ligne de mot du réseau 1' lorsque l'emplacement correspondant contient l'adresse appliquée sur le bus d'adresses A. Bien entendu, les emplacements de la mémoire associative contiendront tous des adresses différentes de manière qu'une seule ligne de mot soit sélectionnée à la fois. Chaque emplacement de la mémoire associative 4 contient, outre un champ d'adresse AF, deux bits d'état, respectivement V et U. Les bits V et U ont pour but de permettre la différenciation, dans la mémoire associative 4, d'un emplacement contenant une adresse d'un emplacement vide et, parmi les emplacements contenant une adresse, d'un emplacement dont les données correspondantes du réseau 1' sont éventuellement réutilisables d'un emplacement définitivement indisponible.

Ainsi, une caractéristique de la présente invention est de prévoir la réutilisation de lignes de mots déjà programmées antérieurement.

Par exemple, lorsque le bit V est à un état actif (par exemple 1), il indique que la ligne de mot correspondante est libre pour une reprogrammation éventuelle et, quand il est à un état inactif (O), il indique que la ligne de mot a déjà été programmée. Lorsque le bit U est à un état actif (par exemple 1), il indique que la ligne de mot correspondante est sélectionnable, et, quand il est à un état inactif (O), il indique que la ligne de mot n'est plus sélectionnable.

On peut également interpréter les états respectifs U et V par couple. Un état "11" indique une entrée libre, c'est-à-dire un état vierge de la ligne de mot correspondante. Un état "01" indique une ligne de mot active, c'est-à-dire programmée. Un état "00" indique une ligne de mot indisponible, c'est-à-dire définitivement perdue.

En lecture, chaque fois qu'une adresse est fournie à la mémoire, cette adresse est comparée aux champs d'adresses AF de la mémoire associative 4 tandis qu'un état actif "01" est comparé aux bits VU. La ligne de mot correspondant à un emplacement de la mémoire associative 4 ne sera sélectionnée que si les bits de son champ d'adresse AF et les bits VU coïncident tous avec les bits de l'adresse présente sur le bus et le couple "01". Une ligne de mot correspondant à un emplacement dont le couple de bits VU est à "00" n'est jamais sélectionnée, quel que soit le contenu du champ d'adresse AF. De même, une ligne de mot correspondant à un emplacement dont le couple de bits VU est à "11" n'est, en lecture, jamais sélectionnée quel que soit le contenu du champ d'adresse AF.

Avec une telle configuration, une ligne de mot prédéterminée peut être associée à une adresse quelconque simplement en écrivant cette adresse dans l'emplacement correspondant de la mémoire associative 4, et en mettant à O et 1 respectivement les bits V et U de cet emplacement. On notera que, en lecture, la mémoire associative 4 remplace aussi bien le décodeur d'adresses que les éléments d'aiguillage d'une mémoire programmable non-volatile classique (figure 1).

Selon l'invention, la mémoire associative 4 est utilisée pour autoriser plusieurs programmations d'une même ligne de mot. On tire profit du fait que l'état d'un point mémoire non-volatile n'est figé que pour un des deux états (O ou 1). En effet, un des deux états d'un point mémoire correspond à un état "non-programmé", et le point mémoire est alors programmable vers l'autre état. Toutefois, une fois programmé, un point mémoire donné ne peut bien entendu pas revenir dans son état "non-programmé". En supposant que l'état initial (non-programmé) d'un point mémoire est 1, une ligne de mots dont les points mémoire contiennent la donnée "11110101" peut ainsi être reprogrammée, par exemple, vers la donnée "01010000". Cette caractéristique de la présente invention sera exposée par la suite en relation avec un exemple de mise en oeuvre d'un procédé de reprogrammation d'une mémoire telle que représentée à la figure 2.

Initialement, quand la mémoire est vierge, les adresses A et les données D sont programmées séquentiellement respectivement dans la mémoire associative 4 et dans le réseau de cellules non-volatiles 1'. Les bits d'état V et U sont, pour chaque ligne utilisée, programmés à l'état "01".

Lorsque la mémoire doit être reprogrammée, on commence par examiner, pour chaque couple d'adresse/données (adresse dans la mémoire associative 4 et données correspondantes dans le réseau matriciel 1'), si les données sont modifiées.

Dans la négative, on passe au couple adresse/données suivant.

Dans l'affirmative, on commence par détecter si les nouveaux bits de données peuvent être reprogrammés à la place des anciens bits dans les points mémoires non-volatiles correspondants.

Si, pour la ligne de mot adressée, la nouvelle donnée n'est pas reprogrammable à la place de l'ancienne, l'adresse correspondante de la ligne de mot est mémorisée comme étant réutilisable et le couple adresse/données est mémorisé comme devant être "relogé", c'est-à-dire programmé dans une autre ligne.

Ainsi, une caractéristique de la présente invention est d'utiliser deux tables, respectivement, de lignes de mot réutilisables et de données à reloger. Ces tables ne sont utilisées que pendant l'exécution d'une séquence de reprogrammation de la mémoire non-volatile. Par conséquent, elles peuvent être prévues temporairement, par exemple, dans la mémoire de travail du microprocesseur chargé de cette opération.

A la fin de la première étape ci-dessus, on se trouve en présence de deux listes (tables) qui doivent être traitées.

Dans une deuxième étape, on traite tous les couples d'adresse/données qui sont dans la table des éléments à reloger. Pour chacun de ces éléments, on vérifie s'il existe un couple de la liste des adresses réutilisables qui peut être reprogrammé avec les nouvelles données. Dans l'affirmative, on reprogramme les données à la place des anciennes données de cette adresse réutilisable, puis on efface l'adresse de la table des adresses réutilisables. Dans la négative, on utilise une adresse entièrement libre s'il en existe encore une de disponible. Les bits d'état VU de cette adresse sont alors modifiés pour placer le bit V à l'état 1 de façon à indiquer que l'emplacement de la mémoire associative est activé. Dans le cas où il ne reste plus d'adresse libre, la mémoire n'est alors plus reprogrammable et doit être changée. Dans une application particulière de la présente invention, il s'agit, par exemple, du cas d'une puce mémoire pleine sur une carte de crédit.

Dans une troisième étape, en supposant que la mémoire n'a pas été déclarée comme n'étant plus programmable, on marque toutes les adresses réutilisables qui subsistent dans la table correspondante, comme étant perdues pour toujours, c'est-à-dire que l'on place les bits d'état U correspondant à l'état 0 dans la mémoire associative 4. Cette étape sert à éviter que deux champs AF de la mémoire associative 4 contiennent la même adresse.

On notera que, pour la mémoire associative 4, chaque emplacement comprend autant de cellules mémoire dans le champ AF que le bus d'adresses A comprend de lignes, plus deux cellules mémoire pour les bits V et U associés à des lignes 5 de commande.

On notera également que la séquence de reprogrammation de la mémoire qui a été décrite ci-dessus peut être exécutée par un équipement de test ou de programmation externe au circuit de mémoire ou peut être réalisée par un microprocesseur.

Un avantage de la présente invention est qu'elle permet d'accroître virtuellement la capacité de reprogrammation d'une mémoire non-volatile pour un nombre donné de lignes supplémentaires par rapport au nombre de lignes correspondant au nombre d'adresses utilisées sur le bus d'adresses.

Un autre avantage de la présente invention est que le procédé de reprogrammation ne dépend pas de la technologie utilisée pour les cellules non-volatiles de la mémoire. On pourra, par exemple, utiliser des cellules anti-fusibles de technologie CMOS classique ou des cellules EPROM classiques.

Un autre avantage de la présente invention est que la mémoire associative 4 peut en outre être utilisée, lors d'un procédé de test initial de la mémoire, pour détecter des rangées défaillantes et utiliser des rangées disponibles comme éléments de redondance. Pour ce faire, on peut, par exemple à la mise sous tension, utiliser un circuit d'auto-test et de réparation qui teste les rangées mémoire et remplit les emplacements de la mémoire associative 4 de valeurs adéquates. Par exemple, un tel circuit d'auto-test parcourt successivement les emplacements de la mémoire associative 4 en écrivant une adresse successive et un 1 dans le bit U de chaque emplacement (le bit V étant à zéro). Ceci rend la rangée mémoire correspondante accessible afin d'être testée classiquement (couple VU à l'état "01").

Si la rangée est bonne, les valeurs sont laissées inchangées dans l'emplacement courant et le circuit procède avec l'emplacement suivant.

Si la rangée est mauvaise, le bit U correspondant est mis à O, de manière à invalider l'adresse correspondante. L'adresse qui a été écrite dans l'emplacement courant est de nouveau écrite dans l'emplacement suivant. Cette procédure est répétée jusqu'à ce que la dernière adresse soit écrite dans un emplacement de la mémoire associative 4, qui correspond à une rangée bonne. Les bits U des emplacements restants sont normalement tous à 1, la valeur contenue dans les champs d'adresse étant arbitraire.

Selon un deuxième mode de mise en oeuvre du procédé de reprogrammation, la recherche d'une ligne de mot réutilisable pour une donnée à reloger s'effectue en cherchant, parmi les couples d'adresse/données réutilisables, le couple pour lequel la donnée nécessitera le moins de modifications, c'est-à-dire le moins de bits à placer dans un état programmé irréversible. Un avantage d'un tel mode de mise en oeuvre par rapport à un simple choix du premier couple disponible dans la liste des couples réutilisables, est que l'on optimise ainsi les possibilités de reprogrammation des différentes lignes de mot et on augmente donc encore la capacité virtuelle de reprogrammation de la mémoire non-volatile.

Bien entendu, la présente invention est susceptible de diverses variantes et modifications qui apparaîtront à l'homme de l'art. En particulier, la réalisation pratique de la mémoire associative 4 et des moyens de stockage temporaires des listes d'adresses réutilisables et des éléments à reloger est à la portée de l'homme du métier à partir des indications fonctionnelles données ci-dessus.

## Revendications

1. Mémoire non-volatile programmable comprenant :
une pluralité de rangées mémoire accessibles par un bus d'adresses (A), le nombre (m+n) de rangées étant supérieur au nombre (m) d'adresses utilisées sur le bus d'adresses ; et
des moyens pour associer des rangées choisies de la mémoire (1') à des adresses respectives ;
**caractérisée en ce que** lesdits moyens comprennent une mémoire associative (4) ayant un emplacement programmable pour chaque rangée mémoire, ledit emplacement ayant un champ d'adresse (AF) et deux bits d'états (V, U), et étant prévu pour, en lecture, sélectionner sa rangée mémoire respective lorsqu'il contient l'adresse présente sur le bus d'adresses et que les deux bits d'états sont respectivement à un état inactif (0) et actif (1).

2. Mémoire selon la revendication 1, **caractérisée en ce que** toutes les adresses utilisées sur le bus d'adresses (A) sont contenues à des emplacements respectifs dont les bits d'état (V, U) sont respectivement à l'état inactif (0) et actif (1), les bits d'état des emplacements restants étant tous deux à un état actif (1), ou tous deux à un état inactif (0).

3. Mémoire selon la revendication 1 ou 2, **caractérisée en ce que** chaque emplacement comprend une pluralité de cellules mémoire correspondant respectivement aux lignes du bus d'adresses (A) et à des lignes de commande (5) des bits d'état (V, U).

4. Procédé de reprogrammation d'une mémoire selon l'une quelconque des revendications 1 à 3, **caractérisé en ce qu'**il consiste à exécuter les étapes successives suivantes :
comparer, pour chaque couple comprenant une adresse dans la mémoire associative (4) et une donnée dans le réseau mémoire (1'), la donnée présente sur un bus de données (D) avec la donnée stockée de façon non-volatile dans le réseau mémoire ;
reprogrammer, si possible, la nouvelle donnée par rapport à l'ancienne donnée ; et
dans le cas contraire, mémoriser l'adresse correspondante comme étant réutilisable et mémoriser le couple d'adresse/donnée comme étant à reloger.

5. Procédé selon la revendication 4, **caractérisé en ce qu'**il consiste, dans une deuxième étape à rechercher, pour chaque couple d'adresse/donnée à reloger, l'existence d'une rangée réutilisable dans laquelle la nouvelle donnée pourrait être reprogrammée avec cette donnée à reloger et, dans la négative, à utiliser une rangée supplémentaire libre pour programmer la donnée correspondante.

6. Procédé selon la revendication 5, **caractérisé en ce qu'**il consiste, lors de l'utilisation d'une nouvelle rangée, à placer les bits d'état (V, U) dans des états respectifs inactif (0) et actif (1).

7. Procédé selon la revendication 5 ou 6, **caractérisé en ce qu'**il consiste, dans une troisième étape, à marquer toutes les adresses réutilisables qui n'ont pas été reprogrammées comme étant invalides en plaçant les deux bits d'états (V, U) correspondants dans un état inactif (0, 0).

## Patentansprüche

1. Programmierbarer nichtflüchtiger Speicher mit:
einer Vielzahl von Speicherzeilen, auf die über einen Adressbus (A) zugegriffen werden kann, wobei die Anzahl (m+n) der Zeilen größer als die Anzahl (m) der auf dem Adressbus verwendeten Adressen ist; und mit
Einrichtungen zum Assoziieren angewählter Zeilen des Speichers (1') mit entsprechenden Adressen;
**dadurch gekennzeichnet, dass** die besagten Einrichtungen einen assoziativen Speicher (4) mit einem programmierbaren Platz für jede Speicherzeile haben, wobei dieser Platz ein Adressfeld (AF) und zwei Statusbits (V, U) hat und dazu dient, um im Lesebetrieb seine entsprechende Speicherzeile auszuwählen, wenn sie die momentane Adresse auf dem Adressbus enthält und wenn von den beiden Statusbits das eine in einem nichtaktiven Status (0) und das andere in einem aktiven Status (1) ist.

2. Speicher nach Anspruch 1, **dadurch gekennzeichnet, dass** sämtliche auf dem Adressbus (A) verwendeten Adressen an entsprechenden Plätzen enthalten sind, von deren Statusbits (V, U) das eine in dem inaktiven Zustand (0) und das andere in dem aktiven Zustand (1) ist, wobei die Statusbits der verbleibenden Plätze beide in einem aktiven Status (1) oder beide in einem inaktiven Status (0) sind.

3. Speicher nach Anspruch 1 oder 2, **dadurch gekennzeichnet, dass** jeder Platz mehrere Speicherzellen aufweist, die jeweils den Leitungen des Adressbus (A) bzw. Steuerleitungen (5) der Statusbits (V, U) zugeordnet sind.

4. Verfahren zum Reprogrammieren eines Speichers nach einem der Ansprüche 1 bis 3, **dadurch gekennzeichnet, dass** die folgenden aneinander anschließenden Schritte ausgeführt werden:
für jedes Paar, das eine Adresse in dem assoziativen Speicher (4) und ein Datum in dem Speichernetzwerk (1') enthält, wird das momentane Datum auf einem Datenbus (D) mit dem in nichtflüchtiger Art in dem Speichernetzwerk gespeicherten Datum verglichen und das neue Datum in Bezug auf das alte Datum reprogrammiert, falls möglich; und
im gegenteiligen Fall wird die entsprechende Adresse als wiederverwendbar und das Paar aus Adresse/Datum als verlagerbar gespeichert.

5. Verfahren nach Anspruch 4, **dadurch gekennzeichnet, dass** in einem zweiten Schritt für jedes zu verlagernde Paar Adresse/Datum das Vorhandensein einer wiederverwendbaren Zeile gesucht wird, in der das neue Datum mit dem zu verlagernden Datum reprogrammiert werden könnte, und dass, im negativen Falle, eine zusätzliche freie Zeile verwendet wird, um das entsprechende Datum zu programmieren.

6. Verfahren nach Anspruch 5, **dadurch gekennzeichnet, dass** bei der Verwendung einer neuen Zeile die Statusbits (V, U) entsprechend in einen inaktiven Status (0) und einen aktiven Status (1) gesetzt werden.

7. Verfahren nach Anspruch 5 oder 6, **dadurch gekennzeichnet, dass** in einem dritten Schritt alle wiederverwendbaren Adressen, die nicht als unwirksam reprogrammiert wurden, markiert werden, indem die beiden entsprechenden Statusbits (V, U) in einen inaktiven Zustand (0, 0) gesetzt werden.

## Claims

1. A programmable non-volatile memory comprising:
a plurality of memory rows accessible over an address bus (A), the number (m+n) of rows being greater than the number (m) of addresses used over the address bus; and
means for associating selected rows of the memory (1') with respective addresses;
**characterized in that** these means comprise an associative memory (4) having a programmable location for each memory row, this location having an address field (AF) and two state bits (V, U), and being provided for, in the read mode, selecting its respective memory row when it contains the address present over the address bus and when the two state bits respectively are in an inactive (0) and active (1) state.

2. The memory of claim 1, **characterized in that** all the addresses used over the address bus (A) are contained at respective locations, the state bits (V, U) of which respectively are at the inactive (0) and active (1) state, the state bits of the remaining locations being both at an active state (1); or both at an inactive state (0).

3. The memory of claim 1 or 2, **characterized in that** each location comprises a plurality of memory cells respectively corresponding to the lines of the address bus (A) and to lines (5) of control of the state bits (V, U).

4. A method of reprogramming of the memory of any of claims 1 to 3, **characterized in that** it consists of executing the following successive steps:
comparing, for each couple comprising an address in the associative memory (4) and a datum in the memory network (1'), the datum present over a data bus (D) with the datum stored in a non-volatile way in the memory network;
reprogramming, if possible, the new datum with respect to the old datum; and
in the opposite case, storing the corresponding address as being reusable and storing the address/datum couple as having to be relocated.

5. The method of claim 4, **characterized in that** it consists, in a second step, of searching for each address/datum couple to be relocated, the existence of a reusable row in which the new datum could be reprogrammed with this datum to be relocated and, if there is none, using a free additional row to program the corresponding datum.

6. The method of claim 5, **characterized in that** it consists, upon use of a new row, of placing the state bits (V, U) in respective inactive (0) and active (1) states.

7. The method of claim 5 or 6, **characterized in that** it consists, in a third step, of marking all the reusable addresses which have not been reprogrammed as being invalid by placing the'two corresponding state bits (V, U) in an inactive state (0, 0).
